# EUROPEAN PATENT APPLICATION

(11) **EP 4 645 378 A1**
(43) Date of publication of application: **05.11.2025**
(21) Application number: 24173913.5
(22) Date of filing: 02.05.2024
(51) Int. Cl.: H01L 21/687

(54) **HIGH PRECISION XY POSITIONING SYSTEM FOR A SEMICONDUCTOR PROCESSING EQUIPMENT**

(71) Applicant: ETEL S.A., 2112 Môtiers (CH)
(72) Inventor: Dragon-Louiset, Marta, 2072 St-Blaise (CH); Soares, Sébastien, 25300 Arçon (FR); Louiset, Raphaël, 2072 St-Blaise (CH)
(74) Representative: P&TS SA (AG, Ltd.)

(57) **Abstract**

The present invention concerns a high-precision positioning system (10) for positioning a payload of a semiconductor processing equipment. The system (10) comprises a fixed base (12), two stationary linear guides (14a, 14b) fixed to the base (12) and extending along the X-direction of a cartesian coordinates system, an X-stage (20), an X-linear motor (16) arranged to move the X-stage (20) along the X-direction, a Y-stage (50) and a Y-linear motor (40) arranged to move the Y-stage (50) along the Y-direction. The X-stage (20) comprises a transversal beam (21) extending along the Y-direction of the cartesian coordinates system and slidably engaged with respective stationary linear guides (14a, 14b). The Y-stage (50) comprising a carriage (52) and at least one air-bearing (60) connected to the carriage (52) and including a pad surface (62) facing a guiding surface (23) of the transversal beam (21). The latter comprises a frame (22) of a first material. The guiding surface (23) comprises a ceramic coating (25) and a layer (24) of a second material between the ceramic coating (25) and the frame (22) of the transversal beam (21). The second material has a coefficient of thermal expansion lower than the coefficient of thermal expansion of said first material and higher than the coefficient of thermal expansion of said ceramic coating.

## Description

### Field of the invention

The present invention relates to the field of positioning systems for the semiconductor industry and more particularly to high-precision XY positioning systems for accurate positioning of a payload of a semiconductor processing equipment, in particular a silicon wafer handling stage.

### Background of the invention

Multi-axis positioning systems generally comprise mechanical bearings arranged to slide along rails to position a stage in an X-Y coordinates system associated to the system. Mechanical bearings have several limitations which prevent the positioning system to address the ever-tightening requirements from the semiconductor industry. These limitations include in particular:
- micron-level parasitic movements or vibrations due to the irregularities on the surface of the rails of the positioning machine along which the mechanical bearings are intended to slide;
- friction occurring between rolling elements of the mechanical bearings and the rails which causes a hysteresis effect to the slides when they come to a stop, whereby positioning the stage in the X-Y coordinates system with an accuracy lower than 100nm is not possible;
- wear generating particles which may become airborne and pollute surfaces, and
- lubrication such as oil or grease, used to limit friction, which also generates volatile particles which may pollute sensitive parts.

Various solutions have been proposed to overcome these limitations. US5,040,431 and US4,916,340, for example, disclose an XY positioning system comprising air bearings slidably mounted against a ceramic beam, such as Silicon Carbide or alumina. Such construction has the advantage of providing both tight flatness tolerance, down to the micron-level and low rugosity down to 0.2 microns.

Yet, ceramic beams have the inconvenience of requiring complex and heavy installations for machining the beam, due to their hardness, thereby increasing the production cost of these systems. In addition, the ceramic, in particular alumina, has a low thermal conductivity. Accordingly, the ceramic beam does not dissipate well the heat generated by the motors. This negatively affects the precision of the system.

### Brief summary of the invention

An aim of the present invention is therefore to provide a high-precision XY positioning system for positioning a payload of a semiconductor processing equipment, which overcomes the above limitations.

This aim is achieved, at least in part, by an XY positioning system for highly accurate positioning of a payload of a semiconductor processing equipment, comprising a fixed base, two stationary linear guides fixed to the base and extending along the X-direction of a cartesian coordinates system, an X-stage, an X-linear motor arranged to move the X-stage along the X-direction, a Y-stage, and a Y-linear motor arranged to move the Y-stage along the Y-direction. The X-stage comprises a transversal beam extending along the Y-direction of the cartesian coordinates system between the two stationary linear guides and two carriages connected to respective ends of the transversal beam and slidably engaged with respective stationary linear guides. The transversal beam comprises a frame of a first material and a guiding surface. The Y-stage comprises a carriage adapted to fixedly receive the payload of the semiconductor processing equipment and at least one air-bearing connected to the carriage. The air-bearing comprises a pad surface facing the guiding surface of the transversal beam. The air-bearing comprises one or more ducts for exhausting pressurized air from the pad surface to create an air film of a predetermined thickness between the guiding surface of the transversal beam and the pad surface.

This guiding surface comprises a ceramic coating and a layer of a second material between the ceramic coating and the frame of the transversal beam. The second material has a coefficient of thermal expansion lower than the coefficient of thermal expansion of the first material of the frame of the transversal beam and higher than the coefficient of thermal expansion of the ceramic coating.

In an embodiment, the Y-linear motor comprises a magnetic track connected to the transversal beam and a coil unit fitted inside the magnetic track. The latter is arranged to extend between two longitudinal sides of the transversal beam along the Y-direction.

In an embodiment, the flatness of the ceramic coating over an area defined by the length and width of the guiding surface is comprised within a range from one to two micrometres.

In an embodiment, the thickness of the air film, when the positioning system is operating, is comprised between three and six micrometres.

In an embodiment, the ceramic coating is made of alumina (Al₂O₃).

In an embodiment, the second material is nickel or a nickel alloy.

In an embodiment, the thickness of the ceramic coating is selected within a range from 200 micrometres to one millimetre.

In an embodiment, the thickness of the second material is selected within a range from 30 micrometres to 200 micrometres, preferably between 40 and 60 micrometres.

In an embodiment, the ceramic coating is impregnated with a resin, for example a phenolic resin.

In an embodiment, the frame of the transversal beam is in aluminum.

In an embodiment, the second material and the ceramic coating are applied respectively on the frame of the transversal beam and on said second material by an Atmospheric Plasma Spraying (APS) process.

### Brief description of the drawings

The invention will be better understood with the aid of the description of embodiments given by way of examples and illustrated by the figures, in which:
- Figure 1 shows a perspective view of the high-precision XY positioning system for positioning a payload of a semiconductor processing equipment, according to an embodiment;
- Figure 2 shows an enlarged view of the Y-stage of the positioning system of Figure 1, taken in the detail circle of Figure 1;
- Figure 3 shows a cross-sectional view of the Y-stage of Figure 2, in a plane perpendicular to the Y-axis;
- Figure 4 shows an enlarged view of Figure 3 at the interface between the guiding surface of the transversal beam and the air-bearing;
- Figure 4a is an enlarged view of the air-bearing against the guiding surface of Figure 4 at the level of the air-bearing ducts,
- Figure 4b is an enlarged view of a portion of the guiding surface of the transversal beam of Figure 4, and
- Figure 5 shows a perspective view of the transversal beam of the X-stage of the positioning system of Figure 1.

### Detailed description of several embodiments of the invention

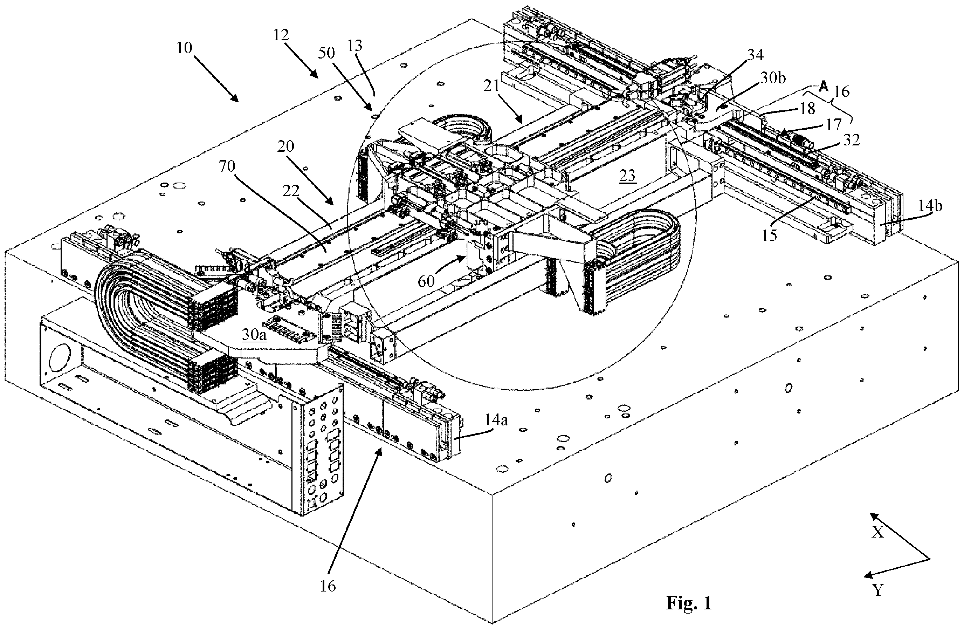

With reference to Figure 1, the high-precision XY positioning system 10 comprises a conventional granite base 12 having a flat and smooth top surface 13. Two stationary linear guides 14a, 14b are fixed to the top surface 13 of the granite base 12 near two opposite ends thereof. These two linear guides 14a, 14b are arranged parallel to each other along an X-direction of a cartesian XY coordinate system to drive an X-stage 20 in both ways along this direction.

The X-stage 20 comprises a transversal beam 21 which extends along the Y-direction of the cartesian coordinates system. Two X-carriages 30a, 30b are connected to respective ends of the transversal beam 21 and are slidably engaged with respective stationary linear guides 14a, 14b. More particularly, each X-carriage 30a, 30b comprises a mechanical bearing (not shown) mounted on a rail 15 fixed along a side of each stationary linear guides 14a, 14b.

The XY positioning system 10 further comprises two X-linear motors 16 each comprising a magnetic track 17 extending along respective linear guides 14a, 14b and a glider 18, comprising a set of coils, fitted in the magnetic track and connected to respective carriages 30a, 30b. The transversal beam 21 is thus moved in the X-direction when the coils of the gliders 18 of the motors 16 are energised. The XY positioning system 10 also comprises two linear encoders for positioning the X-stage 20 along the X-direction. Each linear encoder comprises an encoder scale 32 arranged on an upper side of respective linear guides 14a, 14b and an optical reader 34 mounted on respective carriages 30a, 30b to face respective encoder scale 32.

In a non-illustrated embodiment, the precision XY positioning system may comprise only one X-linear motor to drive one end of the transversal beam along the X-direction while the other end of the transversal beam is merely slidably coupled to a linear guide.

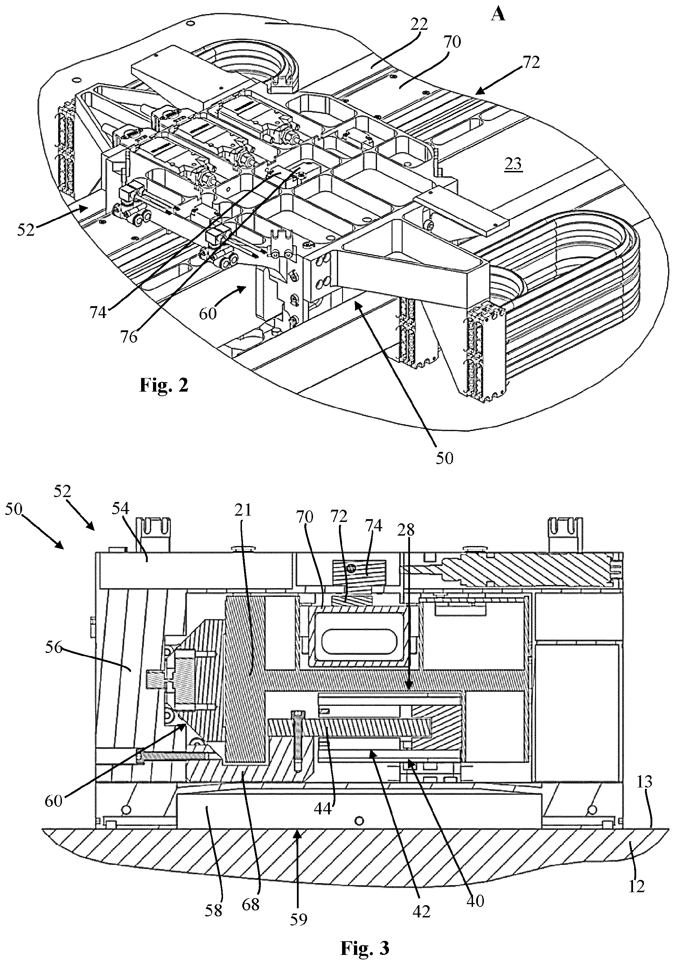

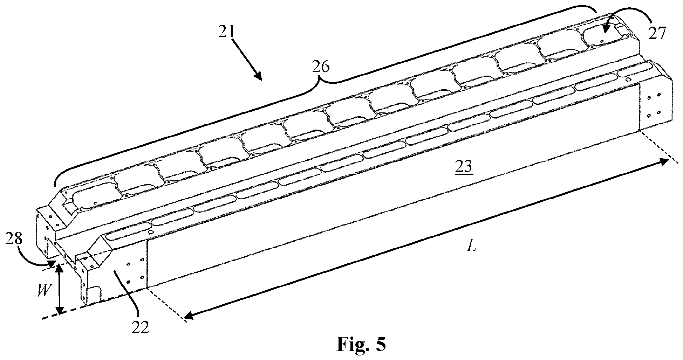

With reference to Figures 3 and 5, the beam 21 has a substantially H-shaped cross-section orthogonal to the beam length. This H-shaped cross-section is constant along most of the entire length of the beam. In a preferred embodiment, the beam 21 is in aluminium or in an aluminium alloy: it advantageously comprises a series of adjacent apertures 27 arranged along its entire length and extending from the upper to the lower part of the beam in order to, on the one hand, decrease the weight while keeping high rigidity of the beam and, on the other hand, increase the thermal exchange surface to efficiently dissipate the heat generated by a Y-linear motor 40 arranged on the beam to drive a Y-stage 50 in the Y-direction along the beam.

With reference to Figures 2 and 3, the Y-stage 50 comprises a Y-carriage 52 comprising an upper part 54 configured to fixedly receive a payload of a semiconductor processing equipment. The lower part of the transversal beam 21 comprises a longitudinal space 28 of a rectangular parallelepiped shape along which is fixed the magnetic track 42 of the Y linear motor 40 as shown in Figure 3. A glider 44, comprising a set of coils, is fitted inside the motor magnetic track 42 and is connected to the carriage 52 of the Y-stage 50 by a connecting bracket 68 to drive the carriage 52 along the transversal beam. This connecting bracket 68 has an L-shaped portion extending below a part of the transversal beam 21 to connect a part of the glider 44 to a side wall 56 of the Y-carriage 52.

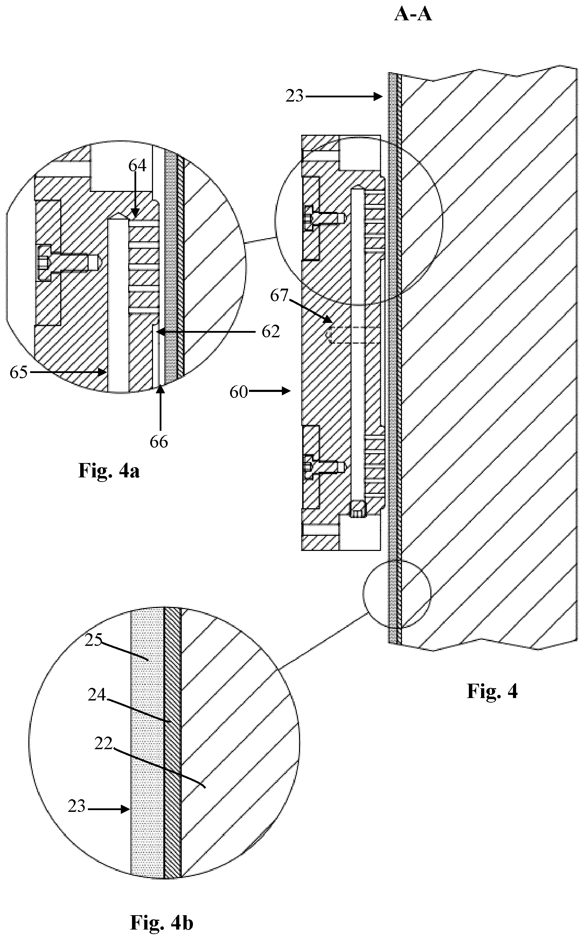

The Y-stage 50 also comprises an air-bearing 60 attached to the same side wall 56 of the Y-carriage 52 such that a flat pad surface 62 of the air-bearing 60 faces a guiding surface 23 of the transversal beam 21 as shown in Figures 4 and 4a. In the depicted embodiment, another air-bearing 58 is mounted on the lower part of the Y-carriage 52 to create an air gap between a pad surface 59 of the air-bearing and the top surface 13 of the granite base 12.

The XY positioning system 10 further comprises a metrological hollow beam 70 with a rectangular transversal cross-section. The metrological beam is arranged to extend along a longitudinal rectangular parallelepiped-shaped space located in an upper portion of the transversal beam 21, without any contact with the latter as illustrated in Figure 3. Both ends of the metrological beam 70 are connected to respective carriages 30a, 30b as shown in Figure 1. The metrological beam 70 is preferably in alumina (Al₂O₃), in silicon carbide or in another material with a low coefficient of thermal expansion.

The XY positioning system 10 comprises a linear encoder for positioning the Y-stage 50 along the transversal beam 21. The encoder comprises an encoder scale 72 mounted along an upper side of the metrological beam 70. In a preferred embodiment, the encoder scale 72 is of the type of 1D+ scale which features an incremental track along the Y-direction as well as additional track that provides the information required for compensation in the perpendicular direction and for angular correction. A first and a second optical reader 74, 76 are thus mounted on the Y-carriage 52, as shown in Figure 2, to read respectively the incremental track and the additional track respectively.

Referring to Figures 4 and 4a, the air-bearing 60 comprises ducts 64 for exhausting pressurized air from the pad surface 62. In a preferred embodiment, the air-bearing further comprises a vacuum channel 67 in communication with vacuum means to suck air from a central part of the pad surface 62. The force of pressurized air impinging upon the guiding surface 23 is sufficient to lift the air-bearing from the guiding surface. The use of both pressured air and vacuum means enables to create an equilibrium condition in which the gas supply volume equals the gas leakage volume to create an air film 66 with laminar flow of a predetermined thickness between the pad surface 62 and the guiding surface 23. Air-bearings configured to operate with pressurized air and a vacuum system are well known in the art and described for example in New Way, "Air Bearing Application and Design Guide", Rev.E, January 2006, https://www.newwayairbearings.com/ sites/default/files/new way_application_and_design_guide_%20Rev_E_2006 -01-18.pdf.

This air film thickness is of the utmost importance since the lower it is, the higher the stiffness of the air-bearing is, and thereby improves the accuracy of the XY positioning system. The flatness of the guiding surface must thus be as low as possible to reduce the air film thickness as much as possible. As a general rule of thumb, the flatness of the guiding surface 23 corresponds approximately to one third of the air film thickness. To make that surface as flat as possible, the guiding surface 23 comprises a ceramic coating 25 with a flatness comprised between one and two micrometers over an area defined by the length L and width W of the guiding surface 23 as illustrated in Figure 5. This flatness therefore translates into an air film 66 having a thickness comprised between three and six micrometres when the XY positioning system is operating.

In order to achieve such flatness, the transversal beam 21 is first milled out of a bock of aluminium alloy, of grade 6082 for example, to obtain at least one lateral side of the beam with a flatness below 15 microns, preferably down to approximately 10 microns. A sanding process is then applied only to the area defined by the length L and width *W* of the guiding surface (Figure 5) in order to provide a surface of a predefined roughness to ensure an optimal adhesion of a first layer 24 (Figures 4 and 4b) of nickel or of a nickel alloy. The application of this first layer is performed by an Atmospheric Plasma Spraying (APS) process. The parameters of this process are set to obtain a layer thickness comprised between 30 micrometres and 200 micrometres and preferably between 40 and 60 micrometres. The size of the grain of nickel or nickel alloy should be preferably comprised in the range from 15 to 90 µm.

Once the first layer 24 is applied, a ceramic coating 25 is applied on this first layer using for example the same APS process and by setting the process parameters to obtain a ceramic coating thickness comprised between 200 micrometres and one millimetre and preferably between 500 and 700 micrometres. The ceramic is preferably alumina (Al₂O₃) but other types of ceramic may be used. The size of the grain of Al₂O₃ should be preferably comprised in the range from 5 to 45 µm.

The role of the first layer is to avoid any cracking of the ceramic coating 25. Indeed, alumina has a low coefficient of thermal expansion and may crack under the thermal expansion of the transversal beam 21 induced by the heating generated the Y-linear motor 40. The nickel or nickel alloy has an intermediate coefficient of thermal expansion with respect to the coefficient of thermal expansion of aluminium and alumina. The first layer of nickel or nickel alloy therefore partially absorbs the expansion of the aluminum beam thereby reducing mechanical stresses on the ceramic coating to avoid any cracking of the ceramic.

In other embodiments, the first layer of nickel or nickel alloy of the guiding surface may be replaced by a layer of another material whose coefficient of thermal expansion is lower than the one of aluminium and higher than the one of alumina or of other types of ceramic.

The ceramic coating 25 is then ground and then lapped down to a flatness comprised between one and two micrometers. More particularly, the ceramic coating may first be ground down to a flatness comprised within the range from 5 to 10 microns and then lapped to its final flatness. The lapping may be carried out with silicon carbide or diamond grains, the size of which is comprised within the range from 15 to 45 microns.

In an embodiment, the ceramic coating may be impregnated with a resin, for example a phenolic resin. This resin advantageously fills in the porosities between ceramic grains. The resin may be sprayed onto the ceramic coating or applied with a paintbrush, preferably before the lapping.

In a non-illustrated advantageous embodiment, the XY positioning system comprises a transversal beam with two longitudinal opposite guiding surfaces provided with the ceramic coating and the intermediate layer obtained by the above description. In this case, the Y-carriage comprises two air-bearings mounted to face respective guiding surfaces of the transversal beam. This design has the advantage of providing symmetry in the distribution of weight while promoting bilateral guidance. Additionally, this design can make use of air-bearings comprising only pressurized air, because the vacuum is not needed to create the preload force of the air-bearings.

While the invention has been illustrated and described in detail in the drawings and foregoing description, such illustration and description are to be considered illustrative or exemplary and not restrictive. It will be understood that changes and modifications may be made by those of ordinary skill within the scope of the appended claims. For example, the mechanical bearings of the X-stage may be replaced by air bearing mounted at both ends of the transversal beam to face a guiding surface disposed along a side of the stationary linear guides extending in the X-direction. Such guiding surface may comprise an intermediate layer and a ceramic coating with the same properties as those described in relation to the guiding surface of the transversal beam.

### List of reference signs

XY positioning system 10
Base 12
   Top surface 13
Stationary linear guides 14a, 14b
   Rails 15
X-linear motor 16
   Magnetic track 17
   Glider 18
X-stage 20
   Transversal beam 21
      Frame 22
      Guiding surface 23
         Nickel layer 24
         Ceramic coating 25
      Heat exchanger 26
         Apertures 27
      Lower groove 28
   X-carriages 30a, 30b
   Linear encoder
      Encoder scale 32
      Optical reader 34
Y-linear motor 40
   Magnetic track 42
   Glider 44
Y-stage 50
   Y-carriage 52
      Upper side 54
      Sides wall 56
      Air bearing 58
         Pad surface 59
   Air-bearings 60
      Pad surface 62
      Ducts 64
      Pressurized air channel 65
      Air film 66
      Vacuum channel 67
   Connecting bracket 68
Metrological beam 70
Linear encoder
   Encoder scale 72
   First optical reader 74
   Second optical reader 76

## Claims

1. An XY positioning system (10) for positioning a payload of a semiconductor processing equipment, the system (10) comprising
a fixed base (12),
two stationary linear guides (14a, 14b) fixed to the base (12) and extending along the X-direction of a cartesian coordinates system,
an X-stage (20) comprising a transversal beam (21) extending along the Y-direction of the cartesian coordinates system between said two stationary linear guides (14a, 14b) and two carriages (30a, 30b) connected to respective ends of the transversal beam (21) and slidably engaged with respective stationary linear guides (14a, 14b), wherein said transversal beam (21) comprises a frame (22) of a first material and a guiding surface (23),
a Y-stage (50) comprising a carriage (52) adapted to fixedly receive the payload and at least one air-bearing (60) connected to the carriage (52) and including a pad surface (62) facing the guiding surface (23) of the transversal beam (21), wherein said at least one air-bearing comprises ducts (64) for exhausting pressurized air from the pad surface (62) to create an air film (66) of a predetermined thickness between said pad surface (62) and said guiding surface (23),
at least one X-linear motor (16) arranged to move the X-stage (20) along the X-direction, and
a Y-linear motor (40) arranged to move the Y-stage (50) along the Y-direction,
**characterized in that** said guiding surface (23) comprises a ceramic coating (25) and a layer (24) of a second material between said ceramic coating (25) and the frame (22) of the transversal beam (21) and **in that** said second material has a coefficient of thermal expansion lower than the coefficient of thermal expansion of said first material and higher than the coefficient of thermal expansion of said ceramic coating.

2. The XY positioning system (10) according to claim 1, wherein the Y-linear motor (40) comprising a magnetic track (42) connected to the transversal beam (21) and a glider (44) fitted inside the magnetic track (42), and wherein said track (42) extends between two longitudinal sides of said beam (21) along the Y-direction.

3. The XY positioning system (10) according to any preceding claim, wherein the flatness of said ceramic coating (16) over an area defined by the length (L) and width (W) of the guiding surface is comprised within a range from one to two micrometres.

4. The XY positioning system (10) according to any preceding claim, wherein thickness of the air film (66) between said pad surface (62) and said guiding surface (23) is comprised between three and six micrometres.

5. The XY positioning system (10) according to any preceding claim, wherein said coating is made of alumina (Al₂O₃).

6. The XY positioning system (10) according to any preceding claim, wherein said second material is nickel of a nickel alloy.

7. The XY positioning system (10) according to any preceding claim, wherein the thickness of the ceramic coating is selected within a range from 200 micrometres to one millimetre.

8. The XY positioning system (10) according to any preceding claim, wherein the thickness of said second material is selected within a range from 30 micrometres to 200 micrometres, preferably between 40 and 60 micrometres.

9. The XY positioning system (10) according to any preceding claim, wherein said ceramic coating (25) is impregnated with a resin, for example a phenolic resin.

10. The XY positioning system (10) according to any preceding claim, wherein the frame (22) of the transversal beam (21) is in aluminum or in an aluminum alloy.

11. The XY positioning system (10) according to any preceding claim, wherein the second material and the ceramic coating (25) are applied respectively on the frame (22) of the transversal beam (21) and on said second material by Atmospheric Plasma Spraying (APS) process.
